**Europäisches Patentamt**

**European Patent Office**

**Office européen des brevets**

(19)

(11) Veröffentlichungsnummer : **0 532 521 B1**

(12) **EUROPÄISCHE PATENTSCHRIFT**

(45) Veröffentlichungstag der Patentschrift :
**12.04.95 Patentblatt 95/15**

(51) Int. Cl.⁶ : **H02H 7/26,** G01R 31/08,
G01R 27/16

(21) Anmeldenummer : **91909068.8**

(22) Anmeldetag : **15.05.91**

(86) Internationale Anmeldenummer :
**PCT/DE91/00407**

(87) Internationale Veröffentlichungsnummer :
**WO 91/19342 12.12.91 Gazette 91/28**

(54) **VERFAHREN ZUR PRÜFUNG VON ANORDNUNGEN.**

(30) Priorität : **01.06.90 DE 4018170**

(43) Veröffentlichungstag der Anmeldung :
**24.03.93 Patentblatt 93/12**

(45) Bekanntmachung des Hinweises auf die
Patenterteilung :
**12.04.95 Patentblatt 95/15**

(84) Benannte Vertragsstaaten :
**CH DE FR GB LI SE**

(56) Entgegenhaltungen :
**EP-A- 0 214 483**
**EP-A- 0 284 546**

(56) Entgegenhaltungen :
**IEEE Transactions on Power Delivery, Band 4,**
**Nr. 4, Oktober 1989, New York, US; Y. Ohura et**
**al.: "Digital distance relay with improved cha-**
**racteristics against distorted transient wave-**
**forms", Seiten 2025-2031**
**IEE Proceedings, Band 130, Nr. 6, November**
**1983, Q.S. Yang et al.: "Microprocessor-based**
**algorithm for high-resistance earth-fault di-**
**stance protection", Seiten 306-310**

(73) Patentinhaber : **SIEMENS**
**AKTIENGESELLSCHAFT**
**Wittelsbacherplatz 2**
**D-80333 München (DE)**

(72) Erfinder : **SEZI, Tevfik**
**Lauenburger Strasse 106**
**D-1000 Berlin 41 (DE)**

EP 0 532 521 B1

**Beschreibung**

Die Erfindung bezieht sich auf ein Verfahren zur Prüfung von Anordnungen, deren Betriebsverhalten durch lineare, zeitinvarante Differentialgleichungen erster Ordnung beschreibbar ist, bei dem

a) Ausgangsgrößen der jeweils zu prüfenden Anordnung während einer entsprechenden Eingangserregung der Anordnung erfaßt, digitalisiert und in einer digitalen Filtereinrichtung bewertet werden, die eine Anzahl von linearphasigen, nichtrekursiven Digitalfiltern (FIR-Filter) eines ersten Typs (mit Gewichtsfaktoren $h_i$) und eines zweiten Typs (mit Gewichtsfaktoren $g_i$) enthält, wobei

a1) die einzelnen Gewichtsfaktoren ($h_i$, $g_i$) der Filter frei vorgegeben werden und

a2) eine Fehlerkorrektur mittels eines Korrekturfaktors durchgeführt wird, der aus den Amplitudengängen der FIR-Filter ersten und zweiten Typs gebildet wird, und

b) die in den Differentialgleichungen vorkommenden Paramter der Anordnung aus den bewerteten Ausgangsgrößen in einer Recheneinheit ermittelt werden.

Ein Verfahren dieser Art ist aus der Offenlegungsschrift DE 37 09 532 A1 bekannt. Mit dem bekannten Verfahren läßt sich die Prüfung von Anordnungen mit relativ hoher Genauigkeit durchführen. Allerdings ist die Zuverlässigkeit der Prüfung daran gebunden, daß die FIR-Filter mit Abtastwerten sinusförmiger Funktionen angeregt werden. Ausgangsgrößen der zu prüfenden Anordnung mit sinusförmigem Verlauf sind jedoch mitunter nicht gegeben, weil die Ausgangsgrößen der jeweils zu prüfenden Anordnung durch Störungen belastet sein können. Dies gilt beispielsweise für den Fall, in dem die zu prüfende Anordnung eine Hochspannungsübertragungsleitung ist und mit dem bekannten Verfahren eine Impedanzmessung (Distanzschutz) oder eine Fehlerortung im Fehlerfalle durchgeführt werden soll. Störungen des sinusförmigen Verlaufs der Ausgangsgrößen einer Hochspannungsübertragungsleitung als zu prüfender Anordnung können durch Sättigung der zur Erfassung der Ausgangsgrößen eingesetzten Meßwandler, durch den im Fehler- bzw. Kurzschlußfall entstehenden Lichtbogen, durch eine Spannungsverlagerung, durch die Eigenschaften ggf. eingesetzter kapazitiver Spannungswandler, durch Leitungskapazitäten und durch systematische Fehler bei der Durchführung der Prüfung selbst, z. B. durch einen Meßspannungs-Offset, hervorgerufen werden. Die Zuverlässigkeit des Prüfungsergebnisses (z. B. Impedanzwert und Fehlerort) ist dann nicht ohne weiteres gegeben.

Der Erfindung liegt daher die Aufgabe zugrunde, daß eingangs angegebene Verfahren zur Prüfung von Anordnungen so weiter zu entwickeln, daß feststellbar ist, ob das Prüfungsergebnis durch den Ausgangsgrößen überlagerte Störgrößen beeinträchtigt ist oder nicht.

Zur Lösung dieser Aufgabe wird bei dem eingangs angegebenen Verfahren erfindungsgemäß

c) eine mit einem Filter des ersten Typs zu bewertende Ausgangsgröße der zu prüfenden Anordnung auch mit einem Filter eines dritten Typs unter Gewinnung einer weiteren bewerteten Ausgangsgröße bewertet,

d) eine mit einem Filter des ersten Typs und mit einem Filter des zweiten Typs zu bewertende Ausgangsgröße der zu prüfenden Anordnung zusätzlich mit einem Filter eines vierten Typs unter Gewinnung einer zusätzlichen bewerteten Ausgangsgröße bewertet, wobei

d1) die Amplituden-Frequenzgänge der Filter so gewählt werden, daß der Quotient aus dem Amplituden-Frequenzgang des Filters des ersten Typs und des Filters des zweiten Typs gleich dem Quotient aus dem Amplituden-Frequenzgang des Filters des dritten Typs und des Filters des dritten Typs, daß

e) in der Recheneinheit mit der weiteren und der zusätzlichen bewerteten Ausgangsgröße die Paramter der zu prüfenden Anordnung in einem weiteren Rechengang errechnet werden und daß

f) in der Recheneinheit die einander entsprechenden Parameter der Anordnung miteinander verglichen werden.

Ein wesentlicher Vorteil des erfindungsgemäßen Verfahrens besteht darin, daß mit ihm festgestellt werden kann, ob die erfaßten Ausgangsgrößen der jeweils zu prüfenden Anordnung von Störgrößen überlagert sind oder nicht. Ist eine Überlagerung vorhanden, dann unterscheiden die sich in dem ersten und dem weiteren Rechengang ermittelten Parameter der zu prüfenden Anordnung relativ stark voneinander; das Prüfungsergebnis ist demzufolge unsicher. Häufig ist der Einfluß von Störgrößen mit zunehmender Prüfzeit rückläufig, so daß in solchen Fällen durch den ständigen Vergleich der mit unterschiedlichen bewerteten Ausgangsgrößen ermittelten Parameter feststellbar ist, wann das Prüfergebnis, z. B. Impedanzwert und Fehlerort bei einer Hochspannungsübertragungsleitung, zuverlässig ist.

Der Vergleich der in den beiden Rechengängen ermittelten, einander entsprechenden Parameter erfolgt vorteilhafterweise in der Form, daß

g) in der Recheneinheit jeweils die Differenz der einander entsprechenden Parameter der zu prüfenden Anordnung gebildet wird und daß

h) die Differenz mit jeweils einem vorgegebenen Grenzwert verglichen wird.

Liegt der Differenzwert unterhalb des vorgegebenen Grenzwertes, dann ist davon auszugehen, daß eine Störgröße nicht oder nicht mehr überlagert ist, so daß dann die errechneten Parameter der zu prüfenden Anordnung den tatsächlichen Parametern entsprechen; ein verfälschtes Meßergebnis ist damit eindeutig erkennbar.

Die Erfindung geht - wie die Offenlegungsschrift DE 37 09 532 A1 -davon aus, daß sich die jeweils zu prüfende Anordnung durch folgende Differentialgleichung (1) beschreiben läßt

$$L_N \cdot \frac{di_N}{dt} + R_N \cdot i = u_N, \quad (1)$$

in der im Falle einer Hochspannungsübertragungsleitung als zu prüfender Anordnung $L_N$ die Netzinduktivität, $R_N$ den Ohmschen Netzwiderstand, $i_N$ den Netzstrom und $u_N$ die Netzspannung bezeichnet. Wie ebenfalls bereits in der DE-37 09 532 beschrieben ist, läßt sich diese Differentialgleichung (1) in eine von Absolutwerten unabhängige Darstellung mit folgender Zeit- und Amplitudennormierung überführen:

$$x = \frac{i_N}{I_{Nm}}$$

$x$ : normierter Netzstrom

$i_N$ : Netzstrom

$I_{Nm}$ : Normierungswert von $i_N$

$$u = \frac{u_N}{U_{Nm}}$$

$u$ : normierte Netzspannung

$u_N$ : Netzspannung

$U_{Nm}$ : Normierungswert von $u_N$

$$a = \frac{1}{\Omega_N} \cdot X_N{'}$$

$a$ : normierte Netzimpedanz

$\Omega_N$ : normierte Netzfrequenz

$$\Omega_N = \omega_N \cdot T_A$$

$\omega_N$ : Netzfrequenz

$T_A$ : Normierung- bzw. Abtastzeit

$$X_N{'} = \frac{X_N}{R_O}$$

$X_N$ : Netzimpedanz von $L_N$

$$X_N = \omega_N \cdot L_N$$

$L_N$ : Netzinduktivität

$$R_O = \frac{U_{Nm}}{I_{Nm}}$$

$R_O$ : Normierungswiderstand

$$b = R_N{'}$$

$b$ : normierter Netzwiderstand

$$R_N{'} = \frac{R_N}{R_O}$$

$R_N$ : Netzwiderstand

Aus der Differentialgleichung (1) wird dann die normierte Differentialgleichung (2):

$$a \cdot \dot{x} = -\, b \cdot x + u \quad (2)$$

Durch Messen der Ausgangsgrößen x und u und mittels der bewerteten Ausgangsgröße $\dot{x}$ zu zwei unterschiedlichen Zeitpunkten können anhand der Gleichung (2) in einen ersten Rechengang die normierten Parameter a und b und daraus die Parameter $L_N$ und $R_N$ der zu prüfenden Anordnung bestimmt werden.

Wenn die Differentialgleichung (1) gilt, dann läßt sich die zu prüfende Anordnung auch durch die folgende Differentialgleichung (3) beschreiben

$$L_N \cdot \frac{d^2 i_N}{dt^2} + R_N \cdot \frac{di_N}{dt} = \frac{du_N}{dt} \quad (3)$$

Durch entsprechende Amplitudennormierung ergibt sich dann die normierte Differentialgleichung (4):

$$a \cdot x = -\, b \cdot \dot{x} + \dot{u}. \quad (4)$$

Wie auch bereits in der DE 37 09 532 A1 beschrieben ist, kann die Ableitung einer Meßgröße durch Wahl eines bestimmten Filters aus der Meßgröße selbst gewonnen werden; das Filter muß differenzierende Eigenschaften aufweisen. Dieses Prinzip kann entsprechend auch auf die Größe u angewendet werden, wenn die Filter des dritten und vierten Typs hinsichtlich ihres Amplituden-Frequenzganges in ihrem Quotienten dem Quotienten des Amplitudenfrequenzganges der Filter des ersten und zweiten Typs entsprechen. Es ist dann auch die Ermittlung der zweiten Ableitung x der Größe x möglich.

Werden also FIR-Filter mit einfach differenzierendem Verhalten und doppelt differenzierendem Verhalten benutzt, die der angegebenen Filterbedingung genügen, dann lassen sich mit derartigen Filtern zunächst die Größen $\dot{u}$, $\dot{x}$ und $\ddot{x}$ gewinnen und durch Messen zu zwei verschiedenen Zeitpunkten aus der Differentialgleichung (3) bzw. (4) nochmals die normierten Parameter a und b bzw. $L_N$ und $R_N$ bestimmen. Die jeweilige Differenz der Werte für den Netzwiderstand $R_N$ und die Netzinduktivität $L_N$ geben, verglichen mit einem vorgegebenen Grenzwert, Auskunft darüber, ob die Überprüfung in unzulässiger Weise bei überlagerter Störgröße stattgefunden hat, oder ob eine Störgrößenüberlagerung nicht vorhanden war, das Prüfergebnis also korrekt ist.

Bei dem erfindungsgemäßen Verfahren haben das Filter des zweiten Typs und das Filter des dritten Typs vorteilhafter Weise die gleiche Filterübertragungsfunktion; dadurch läßt sich der Rechenaufwand verringern.

Als vorteilhaft wird es ferner angesehen, wenn bei dem erfindungsgemäßen Verfahren das FIR-Filter ersten Typs durch ein symmetrisches Zählerpolynom (Gewichtsfaktorenverteilung $h_i = h_{n-i}$) mit geradem Zählergrad n, die FIR-Filter zweiten und dritten Typs durch ein antisymmetrisches Zählerpolynom (Gewichtsfaktorenverteilung $g_i = -g_{n-i}$) mit geradem Zählergrad n und das Filter vierten Typs durch ein symmetrisches Zählerpolynom (Gewichtsfaktorenverteilung $q_i = q_{n-i}$) mit geradem Zählergrad n beschrieben wird.

Ferner wird es als vorteilhaft angesehen, wenn die Gewichtsfaktoren $h_i$ des FIR-Filters ersten Typs mit der Verteilung $h_i = h_{n-i}$ mit geradem Zählergrad n in der Form

$$
\begin{aligned}
h_0 &= h_n &&= 0 \\
h_1 &= h_{n-1} &&= 0 \\
h_2 &= h_{n-2} &&= 1 \\
h_3 & &&= 1 \\
h_{n/2} & &&= 2,
\end{aligned}
$$

die Gewichtsfaktoren $g_i$ der FIR-Filter zweiten und dritten Typs mit der Verteilung $g_i = -g_{n-1}$ mit geradem Zählergrad n in der Form

$$
\begin{aligned}
g_0 &= -g_n &&= 0 \\
g_1 &= -g_{n-1} &&= 1 \\
g_2 &= -g_{n-2} &&= 1 \\
g_3 & &&= 1 \\
g_{n/2} & &&= 0
\end{aligned}
$$

und die Gewichtsfaktoren $q_i$ des FIR-Filters vierten Typls mit der Verteilung $q_i = q_{n-i}$ mit geradem Zählergrad in der Form

$$
\begin{aligned}
q_i &= q_{n-1} \\
q_0 &= q_n &&= -1 \\
q_1 &= q_{n-1} &&= -1 \\
q_2 &= q_{n-2} &&= -1 \\
q_3 &= q_{n-3} &&= 0 \\
q_4 &= q_{n-4} &&= +1 \\
q_n & &&= +2
\end{aligned}
$$

vorgegeben werden.

Der Vorteil der Wahl derartiger Gewichtsfaktoren für die einzelnen Filter besteht darin, daß bei der Bewertung der Ausgangsgrößen der zu prüfenden Anordnung diese lediglich mit einfachen, zumeist ganzen Zahlen multipliziert werden müssen, was bei der Berechnung einen relativ geringen Aufwand verursacht. Außerdem ergibt sich bei einer derartigen Wahl der Gewichtsfaktoren der besondere Vorteil, daß der hier wie bei dem bekannten Verfahren nach der DE 37 09 532 A1 aus den Amplitudengängen der Filter ersten und zweiten Typs zu bestimmende Korrekturfaktor $k_c$ eine konstante Größe ist, der unabhängig von dem gewählten Zählergrad n für die Filterrealisierung eine Konstante ist.

Zur Erläuterung der Erfindung ist in

Figur 1 das Prinzip des erfindungsgemäßen Verfahrens in einem Blockschaltbild, in

Figur 2 ein Zeiger-Diagramm mit den mittels des erfindungsgemäßen Verfahrens im Fehlerfall als Parameter ermittelten Impedanzen einer Hochspannungsübertragungsleitung,

Figur 3 ein Beispiel für die Wahl der Gewichtsfaktoren der FIR-Filter, in

Figur 4 der normierte Amplituden-Frequenzgang der FIR-Filter ersten und zweiten Typs mit Gewichtsfaktoren gemäß Figur 3, und in

Figur 5 der Amplituden-Frequenzgang FIR-Filter dritten und vierten Typs mit Gewichtsfaktoren gemäß Figur 3 darstellt.

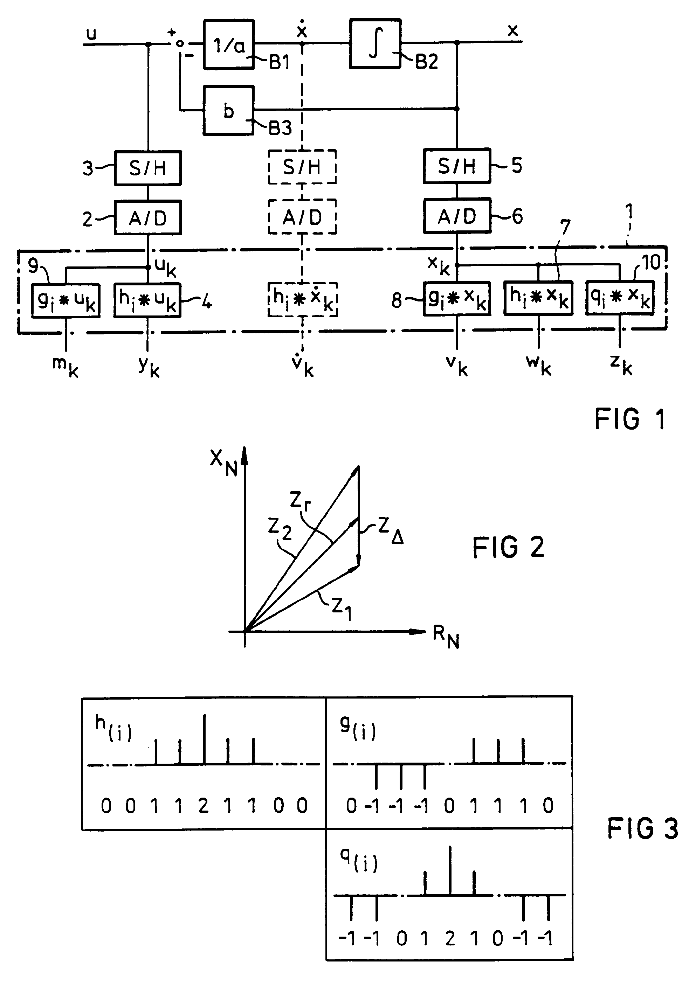

Zur prinzipiellen Erläuterung des Ablaufs des erfindungsgemäßen Verfahrens wird zunächst auf die Figur 1 eingegangen, um im einzelnen darzulegen, wie die Parameter a und b der Differentialgleichungen (2) und (4) einer Hochspannungsübertragungsleitung als zu prüfender Anordnung mittels der erfaßbaren Ausgangsgrößen $U_N$ (Netzspannung) und $I_N$ (Netzstrom) ohne Bildunq der ersten zeitlichen Ableitung des normierten Stromes $\dot{x}$ und der zweiten zeitlichen Ableitung $\ddot{x}$ in jeweils getrennten Vorgängen ermittelt werden können; aus a und b ist dann leicht die Netzimpedanz $X_N$ und der Netzwiderstand $R_N$ errechenbar. Die Ermittlung von a und b geschieht in der Weise, daß die normierten Ausgangsgrößen u und x der zu prüfenden Anordnung - diese in im oberen Teil der Figur 1 durch die Blöcke B1 bis B3 in ihrem Ersatzschaltbild entsprechend der Differentialgleichung (2) einer Hochspannungsübertragungsleitung dargestellt - in einer Filtereinheit 1 bewertet werden. Die Bewertung erfolgt durch Faltungsoperationen, die im Blockschaltbild gemäß Figur 1 durch ein Symbol ∗ gekennzeichnet sind. Die normierte Ausgangsgröße u wird dazu über einen Analog-Digital-Umsetzer 2 mit vorgeordneter Sample-And-Hold-Schaltung 3 einem digitalen FIR-Filter 4 zugeführt. Im Analog-Digital-Umsetzer 2 wird die Ausgangsgröße u nach Abtastung mit einer entsprechend gewählten Abtastzeit $T_A$ in eine Folge $u_k$ umgesetzt. Das FIR-Filter 4 ist ein Filter eines ersten Filtertyps und weist eine symmetrische Gewichtsfaktorenverteilung $h_i$ auf. An dem Ausgang des digitalen FIR-Filters 4 entsteht eine Folge $y_k$, deren Abbildungsvorschrift lautet

$$y_k = \sum_{i=0}^{n} h_i \cdot u_{k-i} \qquad (5)$$

Darüber hinaus wird über eine weitere Sample-And-Hold-Schaltung 5 die normierte Ausgangsgröße x einem weiteren Analog-Digital-Umsetzer 6 zugeführt, dem ein digitaler FIR-Filter 7 nachgeordnet ist, der ebenfalls zum ersten Filtertyp gehört. Am Ausgang des Analog-Digital-Umsetzers 6 entsteht eine Folge $x_k$, aus der nach Bewertung in dem FIR-Filter 7 eine bewertete Ausgangsgröße $w_k$ entsteht, die sich folgendermaßen beschreiben läßt

$$w_k = \sum_{i=0}^{n} h_i \cdot x_{k-i} \cdot \qquad (6)$$

Die abgetasteten Werte $x_k$ werden außerdem einem digitalen FIR-Filter 8 eines zweiten Typs zugeführt, dessen Gewichtsfaktorenverteilung lautet

$$g_i = - g_{n-i}$$

Am Ausgang des digitalen FIR-Filters 8 entsteht eine Folge $v_k$, deren Abbildungsvorschrift lautet:

$$v_k = \sum_{i=0}^{n} g_i \cdot x_{k-i} \qquad (7)$$

Eine Abtastung der Größe $\dot{x}$ mit Umsetzung in einem Analog-Digital-Umsetzer und Bewertung in einem zusätzlichen digitalen FIR-Filter, wie es in der Figur 1 strichliert gezeigt ist, ist nicht erforderlich, da die Folge $v_k$ identisch ist mit der zusätzlichen Folge $\dot{v}_k$.

Die durch die digitalen FIR-Filter 4, 7 und 8 erzeugten bewerteten Ausgangsgrößen $y_k$, $w_k$ und $v_k$ werden so miteiander verknüpft, daß sie der normierten Differentialgleichung (2) genügen:

$$y_k = a \cdot v_k + b \cdot w_k \quad (8)$$

Es handelt sich bei dieser Gleichung um eine von Ableitungen der Ausgangsgröße x freie, lineare Gleichung mit zwei Unbekannten, nämlich den Parametern a und b, welche durch Ermitteln, Bewerten und Einsetzen von jeweils zwei linear voneinander unabhängigen Abtastwerten von u und x lösbar ist.

Die Umgehung der Ableitung der Ausgangsgröße x ist möglich, wenn - wie in der DE 37 09 532 A1 im einzelnen beschrieben - die Amplitudengänge des Filters 4 bzw. 7 des ersten Typs ($H(\Omega)$) und des Filters 8 des zweiten Typs ($G(\Omega)$) der Bedingung (9) genügen

$$G(\Omega) = \Omega \cdot H(\Omega) \text{ bzw.} \quad (9)$$
$$F_1 = G(\Omega)/H(\Omega) = \Omega$$

und für die Übertragungsfunktionen gilt:

$$G(j\Omega) = j\Omega \cdot H(j\Omega) \quad (10)$$

Die Gewichtsfaktoren $h_i$ und $g_i$ der digitalen FIR-Filter 4, 7 und 8 müssen ensprechend gewählt werden.

Wie der Figur 1 ferner zu entnehmen ist, wird die Folge $u_k$ am Ausgang des Analog-Digital-Umsetzers 2 auch in einem weiteren digitalen FIR-Filter 9 bewertet, bei dem es sich vorzugsweise auch um einen Filter des zweiten Typs handelt; prinzipiell kann das Filter 9 von einem dritten Typ sein. Demzufolge entsteht - ähnlich wie oben im Zusammenhang mit der Wirkungsweise des FIR-Filters 8 beschrieben - am Ausgang des weiteren FIR-Filters 9 eine weitere bewertete Ausgangsgröße $m_K$, die der Ableitung in der Ausgangsgröße u nach der Zeit t entspricht. Darüber hinaus wird in der Filtereinheit 1 ein zusätzliches digitales FIR-Filter 10 eingesetzt, bei dem es sich um einen FIR-Filter eines vierten Typs handelt. Hinsichtlich dieses Filters vierten Typs gilt folgende Filterbedingung:

$$Q_2(j\Omega) = j\Omega \cdot G_2(j\Omega) \quad (11)$$

sowie die Frequenzbedingung

$$F_2(\Omega) = Q_2(\Omega) / G_2(\Omega) = \Omega \quad (12)$$

Die Gültigkeit der Frequenzbedingung muß bei $\Omega_N$ und bei möglichst großer Umgebung von $\Omega_N$ erfüllt sein, um die Sicherheit der Rechenergebnisse auch bei Frequenzschwankungen zu garantieren.

Es entspricht dann eine zusätzliche bewertete Ausgangsgröße $z_k$ am Ausgang des digitalen FIR-Filters 10 vierten Typs der zweiten Ableitung der Ausgangsgröße x nach der Zeit so daß, sich die oben aufgeführte normierte Differentialgleichung (4) durch folgende Gleichung darstellen läßt:

$$m_k = a \cdot z_k + b \cdot v_k \quad (13)$$

Bei dieser Gleichung handelt es sich ebenfalls um eine von Ableitungen der Ausgangsgrößen u und x freie, lineare Gleichung mit zwei Unbekannten, nämlich den Parametern a und b, welche durch Ermitteln, Bewerten und Einsetzen von jeweils linear voneinander unabhängigen Abtastwerten von u und x lösbar ist.

Unter Benutzung der Zusammenhänge nach Gleichung (13) lassen sich also nochmals die Parameter a und b der zu prüfenden Anordnung bestimmen und daraus über die obenangegebenen Beziehungen zur Zeit- und Amplitudennormierung der Blindwiderstand $X_N$ von $L_N$ und der ohmsche Netzwiderstand $R_N$ ermitteln.

In einem ersten Rechengang ergibt sich somit unter Benutzung der Ausgangsgrößen $y_k$, $v_k$ und $w_k$ im Falle einer kurzschlußbehafteten Hochspannungsübertragungsleitung als zu prüfender Anordnung eine Kurzschlußimpedanz $Z_1$ aus den Werten $R_{N1}$ und $X_{N1}$, wie sie in Figur 2 durch den entsprechenden Zeiger dargestellt ist. Entsprechend den obigen Darlegungen läßt sich mit den Ausgangsgrößen $m_k$, $v_k$ und $z_k$ außerdem eine Kurzschlußimpedanz $Z_2$ mit $R_{N2}$ und $X_{N2}$ ermitteln; vgl. dazu ebenfalls Figur 2. Beide Zeiger haben die dargestellte Lage zueinander, wenn mit Störgrößen belastete Ausgangsgrößen der Hochspannungsübertragungsleitung verarbeitet worden sind.

Geht man davon aus, daß der tatsächlich richtige Zeiger $Z_r$ der Kurzschlußimpedanz etwa in der Mitte des Differenzvektors $Z_\Delta$ liegen müßte mit

$$Z_\Delta = Z_2 - Z_1, \quad (14)$$

dann ist die Kurzschlußimpedanz mit hinreichender Genauigkeit bestimmbar, wenn

$$|Z_2 - Z_1| < Z_g \quad (15)$$

ist, mit $Z_g$ als einem vorgegebenen Grenzwert; dieser Grenzwert kann beispielsweise 5 % des Zeigers $Z_1$ bzw. $Z_2$ betragen.

Aus Gleichung (15) folgen auch unmittelbar die Gleichungen (16) und (17):

$$X_{N2} - X_{N1} < X_{Ng} \quad (16)$$
$$R_{N2} - R_{N1} < R_{Ng} \quad (17)$$

Für die FIR-Filter gemäß Figur 1 werden die in Figur 3 in ihrer Verteilung aufgeführten Gewichtsfaktoren $h_{(i)}$, $g_{(i)}$ und $q_{(i)}$ vorgegeben. Daraus lassen sich dann nach den bekannten Vorschriften für FIR-Filter der Amplituden-Frequenzgang $H_1(\Omega)$ der FIR-Filter 4 und 7 und der Amplituden-Frequenzgang $G_1(\Omega)$ des FIR-Filters 8 sowie der Amplituden-Frequenzgang $G_2(\Omega)$ des Filters 9 und der Amplituden-Freqenzgang $Q_2(\Omega)$ des FiR-

EP 0 532 521 B1

Filters 10 errechnen.

$$H_1(\Omega) = 2 \cdot \cos\Omega \cdot (1 + 2 \cdot \cos\Omega) \quad (18)$$
$$G_1(\Omega) \, 4 \cdot \sin\Omega \cdot \cos \cdot (1 + 2 \cdot \cos\Omega) \quad (19)$$
$$G_2(\Omega) = 2 \cdot \sin 2\Omega \cdot (1 + 2 \cdot \cos\Omega) \quad (20)$$
$$Q_2(\Omega) = 4 \cdot \sin d\, 2\Omega \cdot \sin \cdot (1 + 2 \cos\Omega) \quad (21)$$

Daraus wiederum ergibt sich für die Freqenzbedingungen $F_1(\Omega)$ und $F_2(\Omega)$:

$$F_1 = F_2 = F = 2 \cdot \sin\Omega \quad (22)$$

Bei der Wahl der angegebenen Gewichtsfaktoren erhält man somit für F einen sinusförmigen Verlauf, der bei kleinen Werten von $\Omega$, wie bei $\Omega_N$, einen fast linearen Verlauf hat; Schwankungen der Netzfrequenz haben daher keinen nennenswerten Einfluß auf das Meß- bzw. Prüfergebnis.

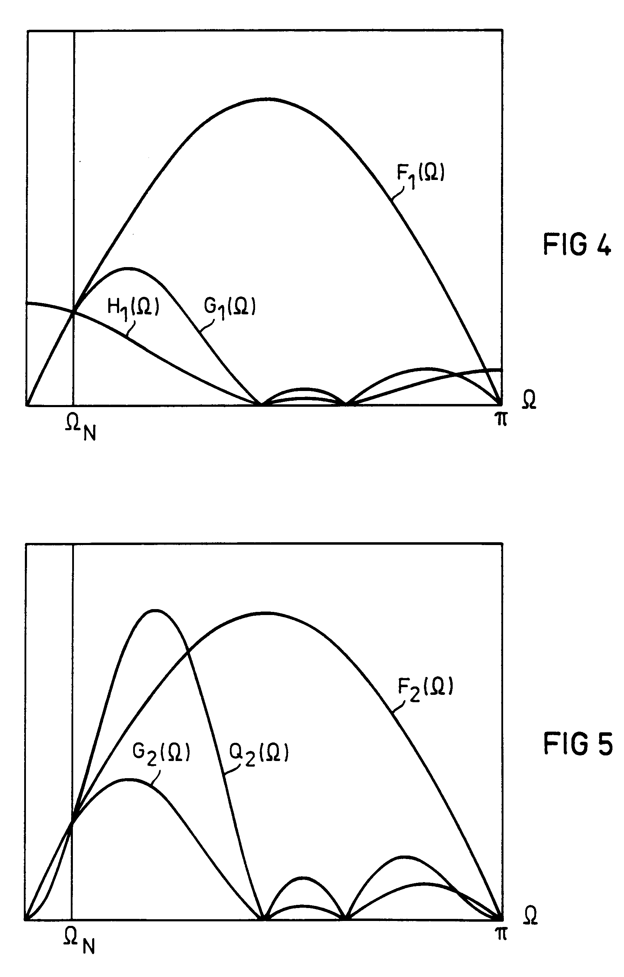

Die Ampliduden-Freqenzgänge nach den Gleichungen (18) bis (21) sind in den Figuren 4 und 5 dargestellt.

Ebenso wie bereits in der DE 37 09 532 A1 offenbart, ist auch bei der Durchführung des erfindungsgemäßen Verfahrens zur Realisierung der FIR-Filter eine Korrektur der Gewichtsfaktoren zur Erfüllung der Filterbedingung bei der Netzfrequenz $\Omega_N$ vorzunehmen. Für den Korrektur $k_c$ gilt bekanntlich:

$$k_c = G_1(\Omega_N)/H_1(\Omega_N) = F(\Omega_N) = 2 \cdot \sin\Omega_N \quad (23)$$

Die korrigierten Gewichtsfaktoren $k_{ci}$ und $g_{ci}$ sowie $q_{ci}$ lassen sich dann für $0 \leq i \leq N$ beschreiben durch:

$$h_{ci} = k_i \quad (24)$$
$$g_{ci} = g_i \cdot k_c \quad (25)$$
$$q_{ci} = q_i \cdot k_c \quad (26)$$

**Patentansprüche**

1. Verfahren zur Prüfung von Anordnungen, deren Betriebsverhalten durch lineare, zeitinvariante Differentialgleichungen erster Ordnung beschreibbar ist, bei dem

   a) Ausgangsgrößen (u,i) der jeweils zu prüfenden Anordnung während einer entsprechenden Eingangserregung der Anordnung erfaßt, digitalisiert und in einer digitalen Filtereinheit (1) bewertet werden, die eine Anzahl von linearphasigen, nichtrekursiven Digitalfiltern (FIR-Filter) eines ersten Typs (3,5) (mit Gewichtsfaktoren $h_i$) und eines zweiten Typs (6) (mit Gewichtsfaktoren $g_i$) enthält, wobei

   a1) die einzelnen Gewichtsfaktoren ($h_i, g_i$) der Filter (4,7,8) frei vorgegeben werden und

   a2) eine Fehlerkorrektur mittels eines Korrekturfaktors ($k_c$) durchgeführt wird, der als Quotient aus den Amplitudengängen (H $(\Omega)$, G $(\Omega)$) der FIR-Filter ersten und zweiten Typs (4,7,8) gebildet wird, und

   b) die in den Differentialgleichungen vorkommenden Parameter der Anordnung aus den bewerteten Ausgangsgrößen ($y_k, v_k, w_k$) in einer Recheneinheit ermittelt werden,

   **dadurch gekennzeichnet, daß**

   c) eine mit einem Filter (4) des ersten Typs zu bewertende Ausgangsgröße (u) der zu prüfenden Anordnung auch mit einem Filter (9) eines dritten Typs unter Gewinnung einer weiteren bewerteten Ausgangsgröße ($m_k$) bewertet wird, daß

   d) eine mit einem Filter (7) des ersten Typs und mit einem Filter (8) des zweiten Typs zu bewertende Ausgangsgröße (i) der zu prüfenden Anordnung zusätzlich mit einem Filter (10) eines vierten Typs (mit Gewichtsfaktoren $q_i$) unter Gewinnung einer zusätzlichen bewerteten Ausgangsgröße ($z_k$) bewertet wird, wobei

   d1) die Amplituden-Frequenzgänge der Filter (4,7,8,9,10) so gewählt werden, daß der Quotient aus dem Amplituden-Frequenzgang des Filters (7) des ersten Typs und des Filters (8) des zweiten Typs gleich dem Quotient aus dem Amplituden-Frequenzgang des Filters (10) des vierten Typs und des Filters (9) des dritten Typs ist, daß

   e) in der Recheneinheit mit der weiteren und der zusätzlichen bewerteten Ausgangsgröße ($m_k, z_k$) nochmals die Parameter der Anordnung in einem weiteren Rechengang errechnet werden und daß

   f) in der Recheneinheit die einander entsprechenden errechneten Parameter der Anordnung miteinander verglichen werden.

2. Verfahren nach Anspruch 1,
   **dadurch gekennzeichnet, daß**

   g) in der Recheneinheit jeweils die Differenz der einander entsprechenden Parameter ($X_{Nz}$, $X_{N1}$, $R_{N1}$, $R_{N2}$) der zu prüfenden Anordnung gebildet wird und daß

   h) die Differenz mit jeweils einem vorgegebenen Grenzwert ($X_{Ng}$, $R_{Ng}$) verglichen wird.

7

3. Verfahren nach Anspruch 1 oder 2,
   **dadurch gekennzeichnet, daß**
   
   i) das Filter (8) des zweiten Typs und das Filter (9) des dritten Typs die gleiche Filterübertragungsfunktion aufweisen.

4. Verfahren nach Anspruch 3,
   **dadurch gekennzeichnet, daß**
   
   j) das FIR-Filter (4,7) ersten Typs durch ein symmetrisches Zählerpolynom (Gewichsfaktorenverteilung $h_i = h_{n-i}$) mit geradem Zählergrad n, die FIR-Filter (8, 9) zweiten und dritten Typs durch ein antisymmetrisches Zählerpolynom (Gewichtsfaktorenverteilung $g_i = -g_{n-i}$) mit geradem Zählergrad n und das Filter (10) vierten Typs durch ein symmetrisches Zählerpolynom (Gewichtsfaktorenverteilung $q_i = q_{n-i}$) mit geradem Zählergrad n beschrieben wird.

5. Verfahren nach einem der vorangehenden Ansprüche,
   **dadurch gekennzeichnet, daß**
   
   k) die Gewichtsfaktoren $h_i$ des FIR-Filters (4,7) ersten Typs mit der Verteilung $h_i = h_{n-i}$ mit geradem Zählergrad n in der Form

$$
\begin{aligned}
h_0 &= h_n &&= 0 \\
h_1 &= h_{n-1} &&= 0 \\
h_2 &= h_{n-2} &&= 1 \\
h_3 & &&= 1 \\
h_{n/2} & &&= 2,
\end{aligned}
$$

l) die Gewichtsfaktoren $g_i$ der FIR-Filter (8,9) des zweiten und dritten Typs mit der Verteilung $g_i = -g_{n-i}$ mit geradem Zählergrad n in der Form

$$
\begin{aligned}
g_0 &= -g_n &&= 0 \\
g_1 &= -g_{n-1} &&= 1 \\
g_2 &= -g_{n-2} &&= 1 \\
g_3 & &&= 1 \\
g_{n/2} & &&= 0
\end{aligned}
$$

und
m) die Gewichtsfaktoren $q_i$ des FIR-Filters (10) vierten Typs mit der Verteilung $q_i = q_{n-i} =$ mit geradem Zählergrad n in der Form

$$
\begin{aligned}
q_0 &= q_n &&= -1 \\
q_1 &= q_{n-1} &&= -1 \\
q_2 &= q_{n-2} &&= -1 \\
q_3 &= q_{n-3} &&= 0 \\
q_4 &= q_{n-4} &&= +1 \\
q_n & &&= +2
\end{aligned}
$$

vorgegeben werden.

**Claims**

1.  A process for testing arrangements, the operating behaviour of which can be described by linear, time-invariant differential equations of the first order, wherein

    a) during a corresponding input excitation of the arrangement, output variables (u, i) of the respective arrangement to be tested are detected, digitalized and weighted in a digital filter unit (1) which contains a number of linear-phase, non-recursive digital filters (FIR) filters of a first type (3, 5) (with weighting factors $h_i$) and of a second type (6) (with weighting factors $g_i$) where

    a1) the individual weighting factors ($h_i$, $g_i$) of the filters (4, 7, 8) are freely predetermined and

    a2) a fault correction is carried out by means of a correction factor ($k_c$) which is formed as quotient from the amplitude responses ($H(\Omega)$, $G(\Omega)$) of the FIR filters of the first and second type (4, 7, 8) and

    b) the parameters of the arrangement occurring in the differential equations are determined from the weighted output variables ($y_k$, $v_k$, $w_k$) in a calculating unit,

    characterised in that

    c) an output variable (u), to be weighted with a filter (4) of the first type, of the arrangement to be tested is also weighted with a filter (9) of a third type with the generating of a further weighted output variable ($m_k$), that

    d) an output variable (i), to be weighted with a filter (7) of the first type and with a filter (8) of the second type, of the arrangement to be tested is additionally weighted with a filter (10) of a fourth type (with weighting factors $q_i$) with the generating of an additional weighted output variable ($z_k$), where

    d1) the amplitude-frequency responses of the filters (4, 7, 8, 9, 10) are selected such that the quotient of the amplitude-frequency response of the filter (7) of the first type and of the filter (8) of the second type is equal to the quotient of the amplitude-frequency response of the filter (10) of the fourth type and of the filter (9) of the third type, that

    e) in the calculating unit, with the further and the additional weighted output variable ($m_k$, $z_k$), the parameters of the arrangement are calculated again in a further calculating operation and that

    f) in the calculating unit the mutually corresponding, calculated parameters of the arrangement are compared with one another.

2.  A process as claimed in Claim 1, characterised in that

    g) in the calculating unit in each case the difference between the mutually corresponding parameters ($X_{Nz}$, $X_{N1}$, $R_{N1}$, $R_{N2}$) of the arrangement to be tested is formed and that

    h) the difference is in each case compared with a predetermined limit value ($X_{Ng}$, $R_{Ng}$).

3.  A process as claimed in Claim 1 or 2, characterised in that

    i) the filter (8) of the second type and the filter (9) of the third type possess the same filter transfer function.

4.  A process as claimed in Claim 3, characterised in that

    j) the FIR filter (4, 7) of the first type is described by a symmetrical numerator polynomial (weighting factor distribution $h_i = h_{n-i}$) with an even numerator power n, the FIR filters (8, 9) of the second and third type are described by an antisymmetrical numerator polynomial (weighting factor distribution $g_i = -g_{n-i}$) with an even numerator power n, and the filter (10) of the fourth type is described by a symmetrical numerator polynomial (weighting factor distribution $q_i = q_{n-i}$) with an even numerator power n.

5.  A process as claimed in one of the preceding claims, characterised in that

    k) the weighting factors $h_i$ of the FIR filter (4, 7) of the first type with the distribution $h_i = h_{n-i}$ with an even numerator power n are predetermined in the form

$$
\begin{aligned}
h_0 \quad &= h_n \quad &= 0 \\
h_1 \quad &= h_{n-1} \quad &= 0 \\
h_2 \quad &= h_{n-2} \quad &= 1 \\
h_3 \quad & \quad &= 1 \\
h_{n/2} \quad & \quad &= 2,
\end{aligned}
$$

l) the weighting factors $g_i$ of the FIR filters (8, 9) of the second and third type with the distribution $g_i = -g_{n-i}$ with an even numerator power n are predetermined in the form

$$
\begin{aligned}
g_0 &= -g_n &&= 0 \\
g_1 &= -g_{n-1} &&= 1 \\
g_2 &= -g_{n-2} &&= 1 \\
g_3 &&&= 1 \\
g_{n/2} &&&= 0
\end{aligned}
$$

and

m) the weighting factors $q_i$ of the FIR filter (10) of the fourth type with the distribution $q_i = q_{n-i}$ with an even numerator power n are predetermined in the form

$$
\begin{aligned}
q_0 &= q_n &&= -1 \\
q_1 &= q_{n-1} &&= -1 \\
q_2 &= q_{n-2} &&= -1 \\
q_3 &= q_{n-3} &&= 0 \\
q_4 &= q_{n-4} &&= +1 \\
q_n &&&= +2
\end{aligned}
$$

## Revendications

1. Procédé pour contrôler des dispositifs, dont le comportement de fonctionnement peut être décrit au moyen d'équations différentielles linéaires du premier ordre, invariantes dans le temps, selon lequel

   a) des grandeurs de sortie (u,i) du dispositif devant être contrôlé, sont détectées pendant une excitation d'entrée correspondante du dispositif, et sont numérisées et évaluées dans une unité de filtre numérique (1), qui comporte un nombre de filtres numériques à phase linéaire, non récursifs (filtres FIR) d'un premier type (3,5) (avec des facteurs de pondération $h_i$) et d'un second type (6) (avec des facteurs de pondération $g_i$),

   a1) les différents facteurs de pondération ($h_i, g_i$) des filtres (4,7,8) étant prédéterminés librement, et

   a2) une correction d'erreur étant exécutée au moyen d'un facteur de correction ($k_c$), qui est formé en tant que quotient à partir des grandeurs d'amplitude ($H(\Omega)$, $G(\Omega)$) des filtres FIR des premier et second types (4,7,8), et

   b) les paramètres du dispositif, qui apparaissent dans les équations différentielles, sont déterminés dans une unité de calcul à partir de grandeurs de sortie évaluées ($y_k$, $v_k$, $w_k$),

   caractérisé par le fait que

   c) une grandeur de sortie (u) du dispositif à contrôler, qui doit être pondérée avec un filtre (4) du premier type, est également pondérée avec un filtre (9) d'un troisième type, moyennant l'obtention d'une autre grandeur de sortie pondérée ($m_k$), et

   d) une grandeur de sortie (u) du dispositif à contrôler, qui doit être pondérée avec un filtre (7) du premier type et avec un filtre (8) du second type, est pondérée en supplément avec un filtre (10) d'un quatrième type (possédant des facteurs de pondération $q_i$), moyennant l'obtention d'une grandeur de sortie pondérée supplémentaire ($z_k$),

   d1) les allures amplitude-fréquence des filtres (4,7,8, 9,10) étant choisies de telle sorte que le quotient entre l'allure amplitude-fréquence du filtre (7) du premier type et du filtre (8) du second type est égal au quotient entre l'allure amplitude-fréquence du filtre (10) du quatrième type et du filtre (9) du troisième type, et

   e) dans l'unité de calcul, les paramètres du dispositif sont calculés à nouveau au cours d'une autre opération de calcul, avec l'autre grandeur de sortie et la grandeur de sortie supplémentaire pondérée

$(m_k, z_k)$, et

f) dans l'unité de calcul, les paramètres calculés du dispositif, qui se correspondent, sont comparés entre eux.

2. Procédé suivant la revendication 1, caractérisé par le fait que

g) dans l'unité de calcul, respectivement la différence entre les paramètres $(X_{Nz}, X_{N1}, R_{N1}, R_{N2})$, qui se correspondent, du dispositif à contrôler est formée, et

h) la différence est comparée à une valeur limite prédéterminée $(X_{Ng}, R_{Ng})$.

3. Procédé suivant la revendication 1 ou 2, caractérisé par le fait que

i) le filtre (8) du second type et le filtre (9) du troisième type possèdent la même fonction de transfert. 4.

4. Procédé suivant la revendication 3, caractérisé par le fait que

j) le filtre FIR (4,7) du premier type est décrit au moyen d'un polynôme de numérateur symétrique (distribution des facteurs de pondération $h_i = h_{n-i}$) avec un degré n pair, les filtres FIR (8,9) des second et troisième types sont décrits par un polynôme de numérateur antisymétrique (distribution des facteurs de pondération $g_i = -g_{n-i}$ comportant un degré n pair, et le filtre (10) du quatrième type est décrit par un polynôme de numérateur symétrique (distribution des facteurs de pondération $q_i = q_{n-i}$) ayant un degré n pair.

5. Procédé suivant l'une des revendications précédentes, caractérisé par le fait que :

k) les facteurs de pondération $h_i$ du filtre FIR (4,7) du premier type, présentant la distribution $h_i = h_{n-i}$ avec un degré n pair de numérateur sont prédéterminés sous la forme

$$
\begin{aligned}
h_0 &= h_n &= 0 \\
h_1 &= h_{n-1} &= 0 \\
h_2 &= h_{n-2} &= 1 \\
h_3 & &= 1 \\
h_{n/2} & &= 2,
\end{aligned}
$$

l) les facteurs de pondération $g_i$ des filtres FIR (8,9) des second et troisième types, présentant la distribution $g_i = -g_{n-i}$ avec un degré n pair de numérateur sont prédéterminés sous la forme

$$
\begin{aligned}
g_0 &= -g_n &= 0 \\
g_1 &= -g_{n-1} &= 1 \\
g_2 &= -g_{n-2} &= 1 \\
g_3 & &= 1 \\
g_{n/2} & &= 0
\end{aligned}
$$

et

m) les facteurs de pondération $q_i$ du filtre FIR (10) du quatrième type, présentant la distribution $q_i = q_{n-i}$ avec un degré n pair du numérateur sont prédéterminés sous la forme

$$
\begin{aligned}
q_0 &= q_n &= -1 \\
q_1 &= q_{n-1} &= -1 \\
q_2 &= q_{n-2} &= -1 \\
q_3 &= q_{n-3} &= 0 \\
q_4 &= q_{n-4} &= +1 \\
q_n & &= +2.
\end{aligned}
$$

FIG 1

FIG 2

FIG 3

FIG 4

FIG 5